# EUROPÄISCHE PATENTANMELDUNG

(11) **EP 4 848 666 A1**
(43) Veröffentlichungstag der Anmeldung: **02.12.2026**
(21) Anmeldenummer: 25179353.5
(22) Anmeldetag: 28.05.2025
(51) Int. Cl.: H04L 12/40, B61L 15/00, H03K 17/56, H03K 19/0175

(54) **SCHNITTSTELLENANORDNUNG SOWIE EISENBAHNWAGEN UND SCHIENENFAHRZEUGE MIT SOLCHEN SCHNITTSTELLENANORDNUNGEN**

(71) Anmelder: Siemens Mobility GmbH, 80997 München (DE)
(72) Erfinder: Günther, Jens-Christian, 31246 Ilsede (DE); Windolf, Wolfgang, 38179 Schwülper (DE)
(74) Vertreter: Siemens Patent Attorneys

(57) **Zusammenfassung**

Die Erfindung bezieht sich unter anderem auf eine Schnittstellenanordnung (100) mit einer internen Schnittstelleneinrichtung (110), die eine erste interne Schnittstelle (I1) und eine zweite interne Schnittstelle (I2) umfasst. Erfindungsgemäß ist vorgesehen, dass die Schnittstellenanordnung (100) eine zumindest ein Halbleiterschaltelement (HSon, HSoff) umfassende Bypasseinrichtung (120) aufweist, die wahlweise in einen Durchleitzustand oder einen Bypass-Zustand schaltbar ist, wobei in dem Durchleitzustand ein erster Durchlasspfad (DP1) der Bypasseinrichtung (120) eine Datensignalübertragung zwischen einer ersten äußeren Schnittstelle (A1) der Schnittstellenanordnung (100) und der ersten internen Schnittstelle (I1) der Schnittstelleneinrichtung (110) erlaubt, aber ein die Schnittstelleneinrichtung (110) überbrückender Bypass-Pfad (BP) der Bypasseinrichtung (120) deaktiviert ist, und wobei in dem Bypass-Zustand der Bypass-Pfad (BP) die erste äußere Schnittstelle (A1) der Schnittstellenanordnung (100) mit einer zweiten äußeren Schnittstelle (A2) der Schnittstellenanordnung (100) verbindet und eine Datensignalübertragung an der Schnittstelleneinrichtung (110) vorbei erlaubt, aber die Datensignalübertragung über den ersten Durchlasspfad (DP1) deaktiviert ist.

## Beschreibung

Die Erfindung bezieht sich auf Schnittstellenanordnungen sowie auf Eisenbahnwagen und Schienenfahrzeuge mit solchen Schnittstellenanordnungen.

Im Bereich der Eisenbahntechnik sind Schnittstellenanordnungen mit Single Pair Ethernet (SPE)-kompatiblen Schnittstelleneinrichtungen bekannt. Die Schnittstellenanordnungen werden dazu eingesetzt, Wagenkomponenten von Eisenbahnwagen wagenübergreifend miteinander zu verbinden. Äußere Schnittstellen der Schnittstellenanordnung können beispielsweise in sogenannten digitalen automatischen Kupplungen integriert sein.

Der Erfindung liegt die Aufgabe zugrunde, eine Schnittstellenanordnung anzugeben, die insbesondere für den Einsatz im Eisenbahnbereich zur Verbindung von Eisenbahnwagen geeignet ist.

Diese Aufgabe wird erfindungsgemäß durch eine Schnittstelleneinrichtung mit den Merkmalen des Patentanspruchs 1 gelöst. Vorteilhafte Ausgestaltungen der erfindungsgemäßen Schnittstellenanordnung sind in Unteransprüchen angegeben.

Danach ist erfindungsgemäß vorgesehen, dass die Schnittstellenanordnung eine zumindest ein Halbleiterschaltelement umfassende Bypasseinrichtung aufweist, die wahlweise in einen Durchleitzustand oder einen Bypass-Zustand schaltbar ist, wobei in dem Durchleitzustand ein erster Durchlasspfad der Bypasseinrichtung eine Datensignalübertragung zwischen einer ersten äußeren Schnittstelle der Schnittstellenanordnung und der ersten internen Schnittstelle der Schnittstelleneinrichtung erlaubt, aber ein die Schnittstelleneinrichtung überbrückender Bypass-Pfad der Bypasseinrichtung deaktiviert ist, und wobei in dem Bypass-Zustand der Bypass-Pfad die erste äußere Schnittstelle der Schnittstellenanordnung mit einer zweiten äußeren Schnittstelle der Schnittstellenanordnung verbindet und eine Datensignalübertragung an der Schnittstelleneinrichtung vorbei erlaubt, aber die Datensignalübertragung über den ersten Durchlasspfad deaktiviert ist.

Ein wesentlicher Vorteil der erfindungsgemäßen Schnittstellenanordnung ist darin zu sehen, dass diese zwei unterschiedliche Betriebsarten vorsieht, nämlich eine Normalbetriebsart (Durchleitzustand), bei der eine Datenübertagung unter Einbezug der internen Schnittstelleneinrichtung erfolgt, und eine Ersatzbetriebsart (Bypass-Zustand), bei der die Datenübertragung an der internen Schnittstelleneinrichtung vorbeigeleitet wird. Die Normalbetriebsart wird vorzugsweise aktiviert, wenn eine zwischen die internen Schnittstellen geschaltete, interne Steuereinrichtung arbeitsfähig ist und Daten, die an der ersten internen Schnittstelle vorliegen und zur Weiterleitung an andere nachgeordnete Schnittstellenanordnungen bestimmt sind, an die zweite interne Schnittstelle weiterleiten kann und Daten, die an der zweiten internen Schnittstelle vorliegen und zur Weiterleitung an andere vorgeordnete Schnittstellenanordnungen bestimmt sind, an die erste interne Schnittstelle weiterleiten kann. Ist die interne Steuereinrichtung hingegen defekt, so wird die Schnittstellenanordnung vorzugsweise in die Ersatzbetriebsart geschaltet, um die Datenübertragung beispielsweise bei Einsatz in einem Wagenverbund über den gesamten Wagenverbund aufrechterhalten zu können. Um mit Blick eines Einsatzes beispielsweise im Eisenbahnbereich dem Umstand Rechnung zu tragen, dass Vibrationen auftreten können, ist zur Sicherung oder zumindest zur Unterstützung eines stabilen Datenübertragungsbetriebs die Schnittstellenanordnung mit zumindest einem Halbleiterschaltelement ausgestattet.

Das Einschalten der Normalbetriebsart bzw. des Durchleitzustands erfolgt vorzugsweise durch ein Durchschaltsignal. Ein solches Durchschaltsignal erzeugt eine in der Schnittstelleneinrichtung integrierte Steuereinrichtung vorzugsweise automatisch, wenn sie in Betrieb ist. Das Einschalten der Ersatzbetriebsart bzw. des Bypass-Zustands erfolgt vorzugsweise im Sinne einer vorgegebenen Rückfallposition automatisch, wenn das Durchschaltsignal fehlt, also dieses von der Steuereinrichtung nicht erzeugt wird.

Das Durchschaltsignal wird vorzugsweise durch eine Schaltspannung ungleich Null bzw. einen Schaltstrom ungleich Null gebildet, die die Schnittstelleneinrichtung, beispielsweise die in der Schnittstelleneinrichtung zwischen der ersten internen und der zweiten internen Schnittstelle angeordnete Steuereinrichtung, bei ordnungsgemäßem Betrieb erzeugt.

Als vorteilhaft wird es angesehen, wenn das zumindest eine Halbleiterschaltelement oder mindestens eines der Halbleiterschaltelemente der Bypasseinrichtung in den ersten Durchlasspfad geschaltet ist und bei Vorliegen des Durchschaltsignals die Datensignalübertragung über den ersten Durchlasspfad erlaubt. Ein Halbleiterschaltelement in dem ersten Durchlasspfad kann in vorteilhafter Weise eine stabile Datenübertragung zwischen der ersten internen Schnittstelle und der ersten äußeren Schnittstelle auch im Falle starker Vibrationen, beispielsweise im Falle einer Fahrt eines mit der Schnittstellenanordnung ausgestatten Schienenfahrzeugs, sicherstellen. Eine durch das Halbleiterschaltelement auftretende Signaldämpfung wegen eines bei Stromfluss auftretenden Spannungsabfalls stellt aufgrund der vergleichsweise kurzen Länge des ersten Durchlasspfads kein relevantes Problem dar.

Demgemäß ist es auch von Vorteil, wenn die Bypasseinrichtung in ihrem Durchleitzustand auch einen zweiten Durchlasspfad aktiviert, der die zweite äußere Schnittstelle der Schnittstellenanordnung mit der zweiten internen Schnittstelle der Schnittstelleneinrichtung verbindet und eine Datensignalübertragung auch über den zweiten Durchlasspfad erlaubt.

Bezüglich des zweiten Durchlasspfads wird es demgemäß ebenfalls als vorteilhaft angesehen, wenn mindestens eines der Halbleiterschaltelemente der Bypasseinrichtung in den zweiten Durchlasspfad geschaltet ist und bei Vorliegen eines Durchschaltsignals die Datensignalübertragung über den zweiten Durchlasspfad erlaubt.

Die Halbleiterschaltelemente in dem oder den Durchlasspfaden sind vorzugsweise solche, die nur bei elektrischer Anregung niederohmig und ansonsten hochohmig sind; bei den Halbleiterschaltelementen in den Durchlasspfaden kann es sich um Halbleiterschaltelemente des Typs "normalerweise aus", beispielsweise also des Anreicherungstyps (Enhancement Mode), handeln, beispielsweise um Anreicherungstyp-FETs, z. B. Anreicherungstyp-MOSFETs.

Alternativ oder zusätzlich kann in vorteilhafter Weise vorgesehen sein, dass das zumindest eine Halbleiterschaltelement oder mindestens eines der Halbleiterschaltelemente der By-passeinrichtung zwischen die erste äußere Schnittstelle der Schnittstellenanordnung und die zweite äußere Schnittstelle der Schnittstellenanordnung geschaltet ist und bei Fehlen des Durchschaltsignals die Datensignalübertragung über den Bypass-Pfad erlaubt. Ein Halbleiterschaltelement in dem Bypass-Pfad kann in vorteilhafter Weise eine stabile Datenübertragung zwischen den äußeren Schnittstellen auch im Falle starker Vibrationen, beispielsweise im Falle einer Fahrt eines mit der Schnittstellenanordnung ausgestatten Schienenfahrzeugs, sicherstellen. Eine durch das Halbleiterschaltelement ggf. hervorgerufene Signaldämpfung wegen eines Spannungsabfalls stellt in der Regel kein großes Problem dar, solange die Anzahl aufeinander folgender Schnittstellenanordnungen, die gleichzeitig im Bypass-Betrieb arbeiten, nicht zu hoch ist.

Die Halbleiterschaltelemente im Bypass-Pfad sind vorzugsweise solche, die bei elektrischer Anregung hochohmig und ansonsten niederohmig sind; bei den Halbleiterschaltelementen im Bypass-Pfad kann es sich um Halbleiterschaltelemente des Typs "normalerweise an", beispielsweise also des Verarmungstyps (Depletion Mode), handeln, beispielsweise um Verarmungstyp-FETs, z. B. Verarmungstyp-MOSFETs.

Alternativ oder zusätzlich kann in vorteilhafter Weise vorgesehen sein, dass zwischen die erste äußere Schnittstelle der Schnittstellenanordnung und die zweite äußere Schnittstelle der Schnittstellenanordnung ein Relaiskontakt der Bypass-Einrichtung geschaltet ist, der bei Fehlen des Durchschaltsignals die Datensignalübertragung zwischen der ersten äußeren Schnittstelle der Schnittstellenanordnung und der zweiten äußeren Schnittstelle der Schnittstellenanordnung erlaubt. Ein Relaiskontakt im Bypass-Pfad kann aufgrund seines in der Regel sehr kleinen elektrischen Widerstands in vorteilhafter Weise dazu beitragen, dass eine bypassbedingt auftretende Signaldämpfung in einem unproblematischen Rahmen bleibt, auch wenn die Anzahl aufeinander folgender Schnittstellenanordnungen, die gleichzeitig im Bypassbetrieb arbeiten, relativ hoch ist. Unter einem Relaiskontakt wird hier eine Kontaktstelle verstanden, an der ein Stromkreis geschaltet wird; der Relaiskontakt verbindet (in einem Einschaltzustand) zwei Leiterteile mechanisch und damit elektrisch miteinander oder hält sie (in dem Ausschaltzustand) getrennt voneinander.

Alternativ oder zusätzlich kann in vorteilhafter Weise vorgesehen sein, dass das zumindest eine Halbleiterschaltelement oder mindestens eines der Halbleiterschaltelemente der Bypasseinrichtung unter Bildung einer Parallelschaltung mit einem Relaiskontakt elektrisch parallelgeschaltet ist und die Parallelschaltung zwischen die erste äußere Schnittstelle der Schnittstellenanordnung und die zweite äußere Schnittstelle der Schnittstellenanordnung geschaltet ist und bei Fehlen des Durchschaltsignals die Parallelschaltung die Datensignalübertragung über den Bypass-Pfad erlaubt. Eine solche Parallelschaltung im Bypass-Pfad kann aufgrund des in der Regel sehr kleinen elektrischen Widerstands des Relaiskontakts in vorteilhafter Weise dazu beitragen, dass eine bypassbedingt auftretende Signaldämpfung in einem unproblematischen Rahmen bleibt, sowie aufgrund der Vibrationsunempfindlichkeit des Halbleiterschaltelements in vorteilhafter Weise dazu beitragen, eine stabile Datenübertragung auch im Falle starker Vibrationen sicherzustellen. Mit anderen Worten kann das Halbleiterschaltelement in Phasen, bei denen aufgrund von Vibrationen eine Datenübertragung über den Relaiskontakt unterbrochen ist, eine Kontinuität in der Datenübertragung gewährleisten, wobei in diesen Phasen ein gewisser Signalstärkenverlust hingenommen wird.

Die internen Schnittstellen der Schnittstelleneinrichtung und die äußeren Schnittstellen der Schnittstellenanordnung sind vorzugsweise jeweils mehrpolig und weisen vorzugsweise zwei oder mehr Schnittstellenanschlüsse auf. Demgemäß ist es vorteilhaft, wenn die Durchlasspfade und der Bypass-Pfad jeweils mehradrig sind.

Vorteilhaft ist es, wenn die Bypasseinrichtung in dem Durchleitzustand für alle Pole jeweils den die Schnittstelleneinrichtung überbrückenden Bypass-Pfad der Bypasseinrichtung deaktiviert.

Vorteilhaft ist es, wenn die Bypasseinrichtung in dem Durchleitzustand für jeden der Pole der ersten Schnittstelle jeweils eine Datensignalübertragung mit dem jeweils korrespondierenden Pol der ersten äußeren Schnittstelle der Schnittstellenanordnung erlaubt.

Vorteilhaft ist es, wenn die Bypasseinrichtung in dem Durchleitzustand für jeden Pol der zweiten Schnittstelle jeweils eine Datensignalübertragung mit dem jeweils korrespondierenden Pol der zweiten äußeren Schnittstelle der Schnittstellenanordnung erlaubt.

Vorteilhaft ist es, wenn die Bypasseinrichtung in dem Bypass-Zustand die Pole der ersten äußeren Schnittstelle der Schnittstellenanordnung mit den korrespondierenden Polen der zweiten äußeren Schnittstelle der Schnittstellenanordnung verbindet und eine Datensignalübertragung an der Schnittstelleneinrichtung vorbei unter Ausschluss der Schnittstelleneinrichtung erlaubt.

Vorteilhaft ist es, wenn die Bypasseinrichtung in dem Bypass-Zustand die Datensignalübertragung zwischen den ersten Schnittstellen einerseits sowie die Datensignalübertragung zwischen den zweiten Schnittstellen andererseits für alle Pole unterbindet.

Vorteilhaft ist es, wenn pro Pol der ersten internen Schnittstelle jeweils zumindest ein Halbleiterschaltelement, das vorzugsweise des Typs "normalerweise aus" ist, zwischen die erste interne Schnittstelle der Schnittstelleneinrichtung und die erste äußere Schnittstelle der Schnittstellenanordnung geschaltet ist.

Alternativ oder zusätzlich kann in vorteilhafter Weise vorgesehen sein, dass pro Pol der zweiten internen Schnittstelle jeweils zumindest ein Halbleiterschaltelement, das vorzugsweise des Typs "normalerweise aus" ist, zwischen die zweite interne Schnittstelle der Schnittstelleneinrichtung und die zweite äußere Schnittstelle der Schnittstellenanordnung geschaltet ist.

Alternativ oder zusätzlich kann in vorteilhafter Weise vorgesehen sein, dass pro Pol der äußeren Schnittstellen jeweils zumindest ein Halbleiterschaltelement, das vorzugsweise des Typs "normalerweise an" ist, zwischen die erste äußere Schnittstelle der Schnittstelleneinrichtung und die zweite äußere Schnittstelle der Schnittstellenanordnung geschaltet ist.

Alternativ oder zusätzlich kann in vorteilhafter Weise vorgesehen sein, dass pro Pol der äußeren Schnittstellen jeweils zumindest ein Relaiskontakt, der vorzugsweise des Typs "normalerweise an" ist, zwischen die erste äußere Schnittstelle der Schnittstelleneinrichtung und die zweite äußere Schnittstelle der Schnittstellenanordnung geschaltet ist.

Vorteilhaft ist es mit Blick auf einen Einsatz beispielsweise im Bereich der Eisenbahntechnik, wenn die ersten Schnittstellen und die zweiten Schnittstellen der Schnittstelleneinrichtung und die der Schnittstellenanordnung jeweils zweipolig sind und die Datensignalübertragung differentiell erfolgt.

Besonders vorteilhaft ist es, wenn die interne Schnittstelleneinrichtung eine Single Pair Ethernet (SPE)-kompatible Schnittstelleneinrichtung ist und die Schnittstelleneinrichtung, insbesondere deren Steuereinrichtung (so vorhanden), das Empfangen, Auswerten, Erzeugen und Ausgeben von SPE-kompatiblen Datensignalen ermöglicht.

Die Erfindung bezieht sich außerdem auf einen Eisenbahnwagen. Diesbezüglich ist erfindungsgemäß vorgesehen, dass dieser mit einer Schnittstellenanordnung, wie oben beschrieben, ausgestattet ist.

Bezüglich des Eisenbahnwagens wird es als vorteilhaft angesehen, wenn die erste äußere Schnittstelle der Schnittstellenanordnung in eine erste digitale automatische Kupplung des Eisenbahnwagens integriert ist und die zweite äußere Schnittstelle der Schnittstellenanordnung in eine zweite digitale automatische Kupplung des Eisenbahnwagens integriert ist. Bei dem Eisenbahnwagen kann es sich um einen Wagen mit eigenem Antrieb oder einen Wagen ohne eigenen Antrieb handeln.

Die Erfindung bezieht sich außerdem auf ein Schienenfahrzeug. Diesbezüglich ist erfindungsgemäß vorgesehen, dass das Schienenfahrzeug einen Verbund, der mit mindestens zwei Eisenbahnwagen, wie oben beschrieben, ausgestattet ist, die über digitale automatische Kupplungen der Eisenbahnwagen miteinander gekuppelt sind, umfasst oder durch einen solchen gebildet ist, wobei in jede der digitalen automatischen Kupplungen des Eisenbahnwagens jeweils eine äußere Schnittstelle einer Schnittstellenanordnung nach einem der voranstehenden Ansprüche integriert ist.

Die Erfindung wird nachfolgend anhand von Ausführungsbeispielen näher erläutert; dabei zeigen beispielhaft:
- Fig. 1: Bestandteile eines Ausführungsbeispiels für ein erfindungsgemäßes Schienenfahrzeug in einer vereinfachten schematischen Draufsicht,
- Figur 2: ein erstes Ausführungsbeispiel für eine erfindungsgemäße Schnittstellenanordnung, die bei dem Schienenfahrzeug gemäß Figur 1 eingesetzt werden kann, und
- Figur 3: ein zweites Ausführungsbeispiel für eine erfindungsgemäße Schnittstellenanordnung, die bei dem Schienenfahrzeug gemäß Figur 1 eingesetzt werden kann.

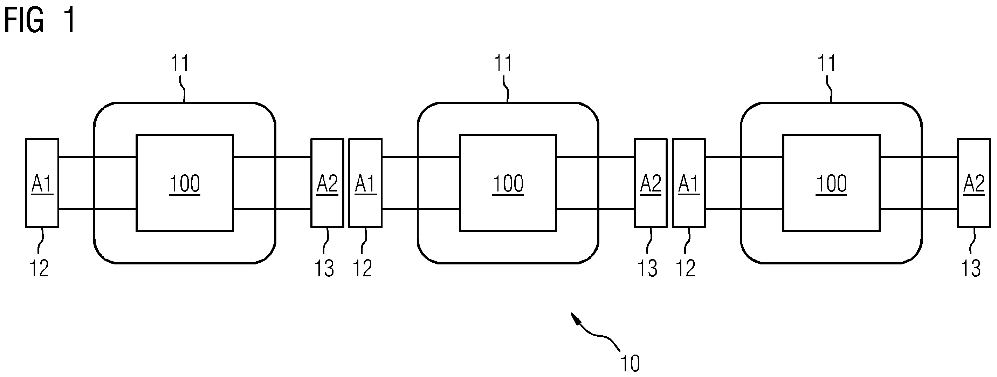

Die Figur 1 zeigt ein Ausführungsbeispiel für ein erfindungsgemäßes Schienenfahrzeug 10, dass aus einem Verbund miteinander verbundener Eisenbahnwagen 11 besteht. Die Eisenbahnwagen 11 sind jeweils mit einer Schnittstellenanordnung 100 ausgestattet.

Bei jedem der Eisenbahnwagen 11 ist jeweils eine erste äußere Schnittstelle A1 der jeweiligen Schnittstellenanordnung 100 in eine erste digitale automatische Kupplung 12 des jeweiligen Eisenbahnwagens 11 integriert und eine zweite äußere Schnittstelle A2 der jeweiligen Schnittstellenanordnung 100 in eine zweite digitale automatische Kupplung 13 des jeweiligen Eisenbahnwagens 11 integriert.

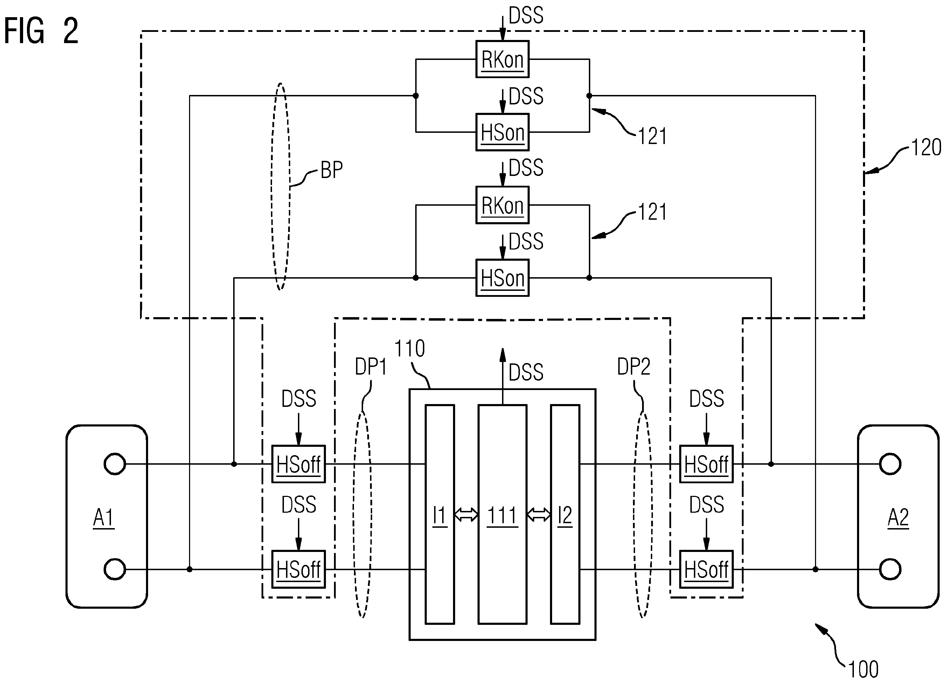

Die Figur 2 zeigt ein erstes Ausführungsbeispiel für eine erfindungsgemäße Schnittstellenanordnung 100, die bei den Eisenbahnwagen 11 gemäß Figur 1 eingesetzt werden kann, näher im Detail. Die Schnittstellenanordnung 100 ist mit einer internen Schnittstelleneinrichtung 110 ausgestattet, die eine erste interne Schnittstelle I1 und eine zweite interne Schnittstelle I1 umfasst. Zwischen den beiden internen Schnittstellen I1 und I2 ist eine Steuereinrichtung 111 geschaltet, die über die internen Schnittstellen I1 und I2 eingehende Datensignale auswerten, darin enthaltene Steuerbefehle verarbeiten sowie Ausgangsdatensignale zur Weiterleitung an andere Schnittstellenanordnungen erzeugen kann.

Mit der Steuereinrichtung 111 können beispielsweise Wagenkomponenten, wie Bremsen, Antriebskomponenten, Klimageräte, usw., oder wageneigene Messeinrichtungen, verbunden sein. Die Steuereinrichtung 111 kann die Wagenkomponenten entsprechend ansteuern, wenn Steuerbefehle über die Schnittstellen eingehen. Auch kann die Steuereinrichtung 111 Messdaten der eigenen Wagenkomponenten an andere Schnittstellenanordnungen und andere Steuereinrichtungen über die Schnittstellen ausgeben.

Die interne Schnittstelleneinrichtung 110 ist vorzugsweise eine Single Pair Ethernet (SPE)-kompatible Schnittstelleneinrichtung, die bzw. deren interne Steuereinrichtung 111 das Empfangen, Auswerten, Erzeugen und Ausgeben von SPE-kompatiblen Datensignalen ermöglicht.

Eine Bypasseinrichtung 120 der Schnittstellenanordnung 100 ist elektrisch zwischen die erste interne Schnittstelle I1 und die erste äußere Schnittstelle A1 sowie zwischen die zweite interne Schnittstelle I2 und die zweite äußere Schnittstelle A2 geschaltet. Die Bypasseinrichtung 120 kann einen Durchleitzustand oder einen Bypass-Zustand annehmen.

Der Betrieb bzw. der Schaltzustand der Bypasseinrichtung 120 hängt von einem Steuersignal, das nachfolgend als Durchschaltsignal DSS bezeichnet wird, ab. Das Durchschaltsignal DSS wird von der Steuereinrichtung 111 erzeugt, wenn bzw. solange diese funktionsfähig in Betrieb ist. Bei fehlender Funktionstüchtigkeit der Steuereinrichtung 111 fehlt demgemäß auch das Durchschaltsignal DSS. Liegt das Durchschaltsignal DSS vor, so wird die Bypasseinrichtung 120 in den Durchleitzustand geschaltet und andernfalls in den Bypass-Zustand. Das Durchschaltsignal DSS wird durch eine Schaltspannung ungleich Null und/oder einen Schaltstrom ungleich Null gebildet und von der Steuereinrichtung 111 bei ordnungsgemäßem Betrieb erzeugt.

In dem Durchleitzustand, also bei Vorliegen des Durchschaltsignals DSS, aktiviert die Bypasseinrichtung 120 einen ersten Durchlasspfad DP1, der die erste äußere Schnittstelle A1 mit der ersten internen Schnittstelle I1 verbindet und eine Datensignalübertragung zwischen den genannten ersten Schnittstellen I1 und A1 erlaubt. Darüber hinaus aktiviert die Bypasseinrichtung 120 in ihrem Durchleitzustand einen zweiten Durchlasspfad DP2, der die zweite äußere Schnittstelle A2 mit der zweiten internen Schnittstelle I2 verbindet und eine Datensignalübertragung zwischen den letztgenannten zweiten Schnittstellen I2 und A2 erlaubt.

In dem Durchleitzustand deaktiviert die Bypasseinrichtung 120 hingegen einen die Schnittstelleneinrichtung 110 überbrückenden Bypass-Pfad BP der Bypasseinrichtung 120, sodass keine Daten an der Schnittstelleneinrichtung 110 vorbeigeleitet werden.

In dem Bypass-Zustand, also bei Fehlen des Durchschaltsignals DSS, arbeitet die Bypasseinrichtung 120 hingegen invers, indem sie den Bypass-Pfad BP aktiviert und dadurch die erste äußere Schnittstelle A1 mit der zweiten äußeren Schnittstelle A2 verbindet und die Datensignalübertragung an der Schnittstelleneinrichtung 110 vorbei erlaubt; im Bypass-Zustand wird die Datensignalübertragung über den ersten und zweiten Durchlasspfad DP1 und DP2 hingegen unterbunden.

Die internen Schnittstellen I1 und I2 der Schnittstelleneinrichtung 110 und die äußeren Schnittstellen A1 und A2 der Schnittstellenanordnung 100 sind jeweils zweipolig und weisen jeweils zwei Schnittstellenanschlüsse auf. Die Durchlasspfade DP1 und DP2 und der Bypass-Pfad BP sind demgemäß jeweils zweiadrig. Die Signalübertragung über die Schnittstellen erfolgt vorzugsweise differentiell.

Bei dem Ausführungsbespiel gemäß Figur 2 ist pro Pol der ersten internen Schnittstelle I1 jeweils ein Halbleiterschaltelement HSoff zwischen die erste interne Schnittstelle I1 und die erste äußere Schnittstelle A1 geschaltet und pro Pol der zweiten internen Schnittstelle I2 ist jeweils ein Halbleiterschaltelement HSoff zwischen die zweite interne Schnittstelle I2 und die zweite äußere Schnittstelle A2 geschaltet. Der Schaltzustand der Durchlasspfade DP1 und DP2 wird somit durch die jeweilige Leitfähigkeit der Halbleiterschaltelemente HSoff bestimmt. Liegt das Durchschaltsignal DSS seitens der Steuereinrichtung 111 vor, so werden die Halbleiterschaltelemente HSoff aktiviert und niederohmig geschaltet, sodass ein Stromfluss freigegeben wird; fehlt das Durchschaltsignal DSS, so sind die Halbleiterschaltelemente HSoff hingegen hochohmig und die Durchlasspfade DP1 und DP2 sind blockiert.

Die Halbleiterschaltelemente in den Durchlasspfaden DP1 und DP2 sind also solche, die nur bei elektrischer Anregung niederohmig sind; bei den Halbleiterschaltelementen HSoff in den Durchlasspfaden DP1 und DP2 kann es sich um Halbleiterschaltelemente des Typs "normalerweise aus", beispielsweise also des Anreicherungstyps (Enhancement Mode), handeln, zum Beispiel um Anreicherungstyp-FETs wie Anreicherungstyp-MOSFETs.

Die Durchlasspfade DP1 und DP2 sind wegen des Einsatzes der Halbleiterschaltelemente HSoff in ihrem aktiven, also stromleitenden Zustand gegenüber Vibrationen unempfindlich und gewährleisten eine sichere störungsfreie Signalübertragung auch während eines Fahrbetriebs des Schienenfahrzeugs 10 gemäß Figur 1. Der Umstand, dass die Halbleiterschaltelemente HSoff im Durchlassbetrieb aufgrund des bei Stromfluss auftretenden Spannungsabfalls stets einen gewissen Verlust an Signalstärke verursachen, ist in den Durchlasspfaden DP1 und DP2 unkritisch, da ein Verlust an Signalstärke bei eingehenden Signalen vor einem Weiterleiten dieser Signale an eine nachgeordnete Schnittstellenanordnung von der in der Schnittstelleneinrichtung 110 integrierten Steuereinrichtung 111 durch Signalverstärkung oder Signalaufbereitung kompensiert werden kann.

Bezüglich des Bypass-Pfads BP ist vorgesehen, dass pro Pol der äußeren Schnittstellen A1 und A2 jeweils ein Relaiskontakt RKon zwischen die erste äußere Schnittstelle A1 und die zweite äußere Schnittstelle A2 geschaltet ist.

Liegt das Durchschaltsignal DSS seitens der Steuereinrichtung 111 vor, so werden die Relaiskontakte RKon in ihren stromtrennenden Zustand geschaltet und es wird ein Stromfluss über den Bypass-Pfad BP blockiert; fehlt das Durchschaltsignal DSS, so fallen die Relaiskontakte RKon hingegen in ihren Grundzustand zurück, in dem die Kontaktelemente der Relaiskontakte RKon geschlossen sind und ein Stromfluss freigegeben wird.

Die Relaiskontakte RKon sind also im Grundzustand, ohne Anregung durch das Durchschaltsignal DSS, niederohmig, sodass der Bypass-Pfad BP aktiv ist, und bei Vorliegen des Durchlasssignals hochohmig bzw. im Sperrzustand. Um diese Arbeitsweise der Relaiskontakte RKon zu gewährleisten, können diese beispielsweise jeweils einen Bestandteil eines Relais bilden, dessen Kontaktelemente beispielsweise durch eine Federkraft aufeinandergedrückt werden und nur bei einem Stromfluss durch einen elektromagnetischen Antrieb beispielsweise in Form eines Ankers und einer Spule voneinander getrennt werden. Die Relaiskontakte RKon sind also vom Typ "normalerweise an".

Die Bypass-Pfade BP sind aufgrund des Einsatzes der Relaiskontakte RKon zwar gegenüber Vibrationen empfindlich, im störungsfreien bzw. durchgeschalteten Zustand sind sie jedoch im Vergleich zu Halbleiterschaltern sehr niederohmig und gewährleisten einen verlustarmen Bypass-Betrieb. Es können somit Kaskaden an Schnittstellenanordnungen bzw. mehrere unmittelbar aneinander angrenzende Schnittstellenanordnungen gleichzeitig im Bypass-Betrieb betrieben werden, ohne einen signifikanten Signalverlust durch kaskadenbedingte Signaldämpfung befürchten zu müssen, wie dies bei einem alleinigen Einsatz von Halbleiterschaltelementen der Fall wäre.

Bezüglich des Bypass-Pfads BP ist bei dem ersten Ausführungsbeispiel außerdem vorgesehen, dass pro Pol der äußeren Schnittstellen A1 und A2 jeweils ein Halbleiterschaltelement HSon des Typs "normalerweise an", also beispielsweise des Verarmungstyps (Depletion Mode), zwischen die erste äußere Schnittstelle A1 und die zweite äußere Schnittstelle A2 geschaltet ist. Die letztgenannten Halbleiterschaltelemente HSon sind dabei jeweils zu einem zugeordneten Relaiskontakt RKon unter Bildung einer Parallelschaltung 121 parallelgeschaltet.

Die Halbleiterschaltelemente HSon des Verarmungstyps sind ohne Steuerspannung also "normalerweise an", weil ohne Anlegen einer Spannung stets ein stromführender Kanal vorhanden ist, der einen Stromfluss ermöglicht; erst durch Anlegen einer Sperrspannung wird der stromführende Kanal "verarmt", wodurch der Stromfluss reduziert oder unterbrochen wird. Bei den Halbleiterschaltelementen HSon im Bypass-Pfad BP kann es sich beispielsweise um Verarmungstyp-FETs, z. B. Verarmungstyp-MOSFETs, handeln.

Der Bypass-Pfad BP wird durch die zusätzlich vorgesehenen Halbleiterschaltelemente HSon gegenüber Vibrationen unempfindlicher und zeigt in seinem aktiven, also stromleitenden Zustand eine bessere Signalübertragung während eines Fahrbetriebs, als dies ohne die Halbleiterschaltelemente HSon der Fall wäre. Der Umstand, dass die Halbleiterschaltelemente HSon im Durchlassbetrieb einen Spannungsabfall verursachen, ist unproblematisch, weil die Relaiskontakte RKon - im zeitlichen Verlauf fast durchgängig, von kurzen vibrationsbedingten Störungen abgesehen - einen Stromfluss an den Halbleiterschaltelementen vorbei ermöglichen und den Gesamtwiderstand der Parallelschaltungen - im Vergleich zum Widerstand der Halbleiterschaltelemente HSon allein - deutlich reduzieren. Lediglich in den kurzen Phasen von Unterbrechungen des Stromflusses durch die Relaiskontakte RKon im Falle von Vibrationen kommt es zu einer gewissen Reduktion der Signalstärke aufgrund des erhöhten Gesamtwiderstands der jeweiligen Parallelschaltung 121, jedoch hat dies in der Gesamtbetrachtung auf eine Kaskade hintereinander geschalteter Schnittstellenanordnungen statistisch gesehen keinen relevanten Einfluss auf den Signalübertragungsbetrieb.

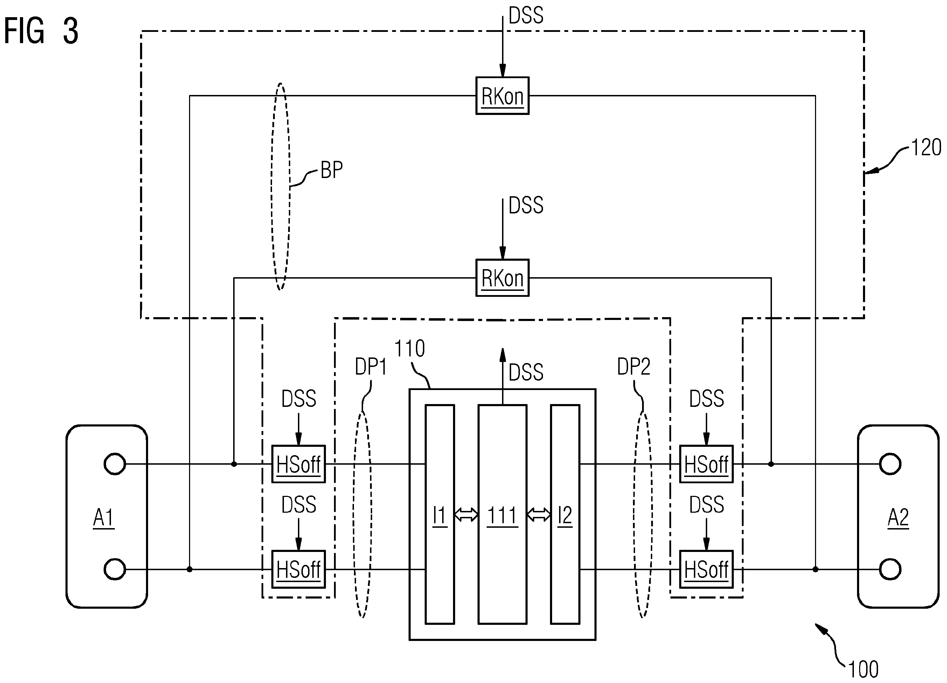

Die Figur 3 zeigt ein zweites Ausführungsbeispiel für eine erfindungsgemäße Schnittstellenanordnung 100, die bei dem Schienenfahrzeug 10 gemäß Figur 1 eingesetzt werden kann, näher im Detail. Die Schnittstellenanordnung 100 gemäß Figur 3 unterscheidet sich von dem ersten Ausführungsbeispiel gemäß Figur 2 lediglich in der Ausgestaltung des Bypass-Pfads BP der Bypasseinrichtung 120.

Bei der Bypasseinrichtung 120 gemäß Figur 3 wird der Bypass-Pfad BP allein durch einen Relaiskontakt RKon pro Signalleitung bzw. pro Pol gebildet. Im Unterschied zu dem ersten Ausführungsbeispiel gemäß Figur 2 fehlen also die parallelgeschalteten Halbleiterschaltelemente HSon. Im Falle von Vibrationen kann es somit zu zeitweiser Unterbrechung der Datenübertagung im Bypassbetrieb kommen, jedoch wird dies bei dem zweiten Ausführungsbeispiel, beispielsweise aus Kostengründen mit Blick auf eine möglichst geringe Anzahl an Schaltelementen hingenommen. Fehler durch eine zeitweise Unterbrechung der Datenübertagung im Bypassbetrieb können durch den Einsatz fehlerkorrigierender oder fehlerresistenter Kodierverfahren minimiert werden.

Abschließend sei erwähnt, dass die Merkmale aller oben beschriebenen Ausführungsbeispiele untereinander in beliebiger Weise kombiniert werden können, um weitere andere Ausführungsbeispiele der Erfindung zu bilden.

Auch können alle Merkmale von Unteransprüchen jeweils für sich mit jedem der nebengeordneten Ansprüche kombiniert werden, und zwar jeweils für sich allein oder in beliebiger Kombination mit einem oder mehreren anderen Unteransprüchen, um weitere andere Ausführungsbeispiele zu erhalten.

### Bezugszeichenliste

- 10: Schienenfahrzeug
- 11: Eisenbahnwagen
- 12: erste digitale automatische Kupplung
- 13: zweite digitale automatische Kupplung
- 100: Schnittstellenanordnung
- 110: interne Schnittstelleneinrichtung
- 111: Steuereinrichtung
- 120: Bypasseinrichtung
- 121: Parallelschaltung

- A1: erste äußere Schnittstelle
- A2: zweite äußere Schnittstelle
- BP: Bypass-Pfad
- DP1: erster Durchlasspfad
- DP2: zweiter Durchlasspfad
- DSS: Durchschaltsignal
- HSoff: Halbleiterschaltelement
- HSon: Halbleiterschaltelement
- I1: erste interne Schnittstelle
- I2: zweite interne Schnittstelle
- RKon: Relaiskontakt

## Patentansprüche

1. Schnittstellenanordnung (100) mit einer internen Schnittstelleneinrichtung (110), die eine erste interne Schnittstelle (I1) und eine zweite interne Schnittstelle (I2) umfasst, **dadurch gekennzeichnet, dass**
- die Schnittstellenanordnung (100) eine zumindest ein Halbleiterschaltelement (HSon, HSoff) umfassende Bypasseinrichtung (120) aufweist, die wahlweise in einen Durchleitzustand oder einen Bypass-Zustand schaltbar ist,
- wobei in dem Durchleitzustand ein erster Durchlasspfad (DP1) der Bypasseinrichtung (120) eine Datensignalübertragung zwischen einer ersten äußeren Schnittstelle (A1) der Schnittstellenanordnung (100) und der ersten internen Schnittstelle (I1) der Schnittstelleneinrichtung (110) erlaubt, aber ein die Schnittstelleneinrichtung (110) überbrückender Bypass-Pfad (BP) der Bypasseinrichtung (120) deaktiviert ist, und
- wobei in dem Bypass-Zustand der Bypass-Pfad (BP) die erste äußere Schnittstelle (A1) der Schnittstellenanordnung (100) mit einer zweiten äußeren Schnittstelle (A2) der Schnittstellenanordnung (100) verbindet und eine Datensignalübertragung an der Schnittstelleneinrichtung (110) vorbei erlaubt, aber die Datensignalübertragung über den ersten Durchlasspfad (DP1) deaktiviert ist.

2. Schnittstellenanordnung (100) nach Anspruch 1,
**dadurch gekennzeichnet, dass**
das zumindest eine Halbleiterschaltelement (HSoff) oder mindestens eines der Halbleiterschaltelemente (HSoff) der Bypasseinrichtung (120) in den ersten Durchlasspfad (DP1) geschaltet ist und bei Vorliegen eines Durchschaltsignals (DSS) die Datensignalübertragung über den ersten Durchlasspfad (DP1) erlaubt.

3. Schnittstellenanordnung (100) nach einem der voranstehenden Ansprüche,
**dadurch gekennzeichnet, dass**
das zumindest eine Halbleiterschaltelement (HSon) oder mindestens eines der Halbleiterschaltelemente (HSon) der Bypasseinrichtung (120) zwischen die erste äußere Schnittstelle (A1) der Schnittstellenanordnung (100) und die zweite äußere Schnittstelle (A2) der Schnittstellenanordnung (100) geschaltet ist und bei Fehlen des Durchschaltsignals (DSS) die Datensignalübertragung über den Bypass-Pfad (BP) erlaubt.

4. Schnittstellenanordnung (100) nach einem der voranstehenden Ansprüche,
**dadurch gekennzeichnet, dass**
zwischen die erste äußere Schnittstelle (A1) der Schnittstellenanordnung (100) und die zweite äußere Schnittstelle (A2) der Schnittstellenanordnung (100) ein Relaiskontakt (RKon) der Bypass-Einrichtung geschaltet ist, der bei Fehlen des Durchschaltsignals (DSS) die Datensignalübertragung zwischen der ersten äußeren Schnittstelle (A1) der Schnittstellenanordnung (100) und der zweiten äußeren Schnittstelle (A2) der Schnittstellenanordnung (100) erlaubt.

5. Schnittstellenanordnung (100) nach einem der voranstehenden Ansprüche,
**dadurch gekennzeichnet, dass**
- das zumindest eine Halbleiterschaltelement (HSon) oder mindestens eines der Halbleiterschaltelemente (HSon) der Bypasseinrichtung (120) unter Bildung einer Parallelschaltung (121) mit einem Relaiskontakt (RKon) elektrisch parallelgeschaltet ist und
- die Parallelschaltung (121) zwischen die erste äußere Schnittstelle (A1) der Schnittstellenanordnung (100) und die zweite äußere Schnittstelle (A2) der Schnittstellenanordnung (100) geschaltet ist und bei Fehlen des Durchschaltsignals (DSS) die Datensignalübertragung über den Bypass-Pfad (BP) erlaubt.

6. Schnittstellenanordnung (100) nach einem der voranstehenden Ansprüche,
**dadurch gekennzeichnet, dass**
die Bypasseinrichtung (120) in dem Durchleitzustand einen zweiten Durchlasspfad (DP2) aktiviert, der die zweite äußere Schnittstelle (A2) der Schnittstellenanordnung (100) mit der zweiten internen Schnittstelle (I2) der Schnittstelleneinrichtung (110) verbindet und eine Datensignalübertragung über den zweiten Durchlasspfad (DP2) erlaubt.

7. Schnittstellenanordnung (100) nach Anspruch 6,
**dadurch gekennzeichnet, dass**
das zumindest eine Halbleiterschaltelement (HSoff) oder mindestens eines der Halbleiterschaltelemente (HSoff) der Bypasseinrichtung (120) in den zweiten Durchlasspfad (DP2) geschaltet ist und bei Vorliegen eines Durchschaltsignals (DSS) die Datensignalübertragung über den zweiten Durchlasspfad (DP2) erlaubt.

8. Schnittstellenanordnung (100) nach einem der voranstehenden Ansprüche,
**dadurch gekennzeichnet, dass**
das Durchschaltsignal (DSS) durch eine Schaltspannung ungleich Null oder einen Schaltstrom ungleich Null gebildet wird, die die Schnittstelleneinrichtung (110) bei ordnungsgemäßem Betrieb erzeugt.

9. Schnittstellenanordnung (100) nach einem der voranstehenden Ansprüche,
**dadurch gekennzeichnet, dass**
- die internen Schnittstellen (I1, I2) der Schnittstelleneinrichtung (110) und die äußeren Schnittstellen (A1, A2) der Schnittstellenanordnung (100) jeweils mehrpolig sind und
- die Durchlasspfade (DP1, DP2) und der Bypass-Pfad (BP) jeweils mehradrig sind.

10. Schnittstellenanordnung (100) nach Anspruch 9,
**dadurch gekennzeichnet, dass**
- pro Pol der ersten Schnittstellen (I1, A1) jeweils zumindest ein Halbleiterschaltelement (HSoff), das vorzugsweise des Typs "normalerweise aus" ist, zwischen die erste interne Schnittstelle (I1) der Schnittstelleneinrichtung (110) und die erste äußere Schnittstelle (A1) der Schnittstellenanordnung (100) geschaltet ist, und/oder
- pro Pol der zweiten Schnittstellen (I2, A2) jeweils zumindest ein Halbleiterschaltelement (HSoff), das vorzugsweise des Typs "normalerweise aus" ist, zwischen die zweite interne Schnittstelle (I2) der Schnittstelleneinrichtung (110) und die zweite äußere Schnittstelle (A2) der Schnittstellenanordnung (100) geschaltet ist, und/oder
- pro Pol der äußeren Schnittstellen (A1, A2) jeweils zumindest ein Halbleiterschaltelement (HSon), das vorzugsweise des Typs "normalerweise an" ist, zwischen die erste äußere Schnittstelle (A1) der Schnittstelleneinrichtung (110) und die zweite äußere Schnittstelle (A2) der Schnittstellenanordnung (100) geschaltet ist und/oder
- pro Pol der äußeren Schnittstellen (A1, A2) jeweils zumindest ein Relaiskontakt (RKon), der vorzugsweise des Typs "normalerweise an" ist, zwischen die erste äußere Schnittstelle (A1) der Schnittstelleneinrichtung (110) und die zweite äußere Schnittstelle (A2) der Schnittstellenanordnung (100) geschaltet ist.

11. Schnittstellenanordnung (100) nach Anspruch 9 oder 10,
**dadurch gekennzeichnet, dass**
- die Bypasseinrichtung (120) in dem Durchleitzustand für jeden der Pole der ersten internen Schnittstelle (I1) jeweils eine Datensignalübertragung mit dem jeweils korrespondierenden Pol der ersten äußeren Schnittstelle (A1) der Schnittstellenanordnung (100) erlaubt,
- die Bypasseinrichtung (120) in dem Durchleitzustand für jeden Pol der zweiten internen Schnittstelle (I2) jeweils eine Datensignalübertragung mit dem jeweils korrespondierenden Pol der zweiten äußeren Schnittstelle (A2) der Schnittstellenanordnung (100) erlaubt,
- die Bypasseinrichtung (120) in dem Durchleitzustand für alle Pole der äußeren Schnittstellen (A1, A2) jeweils den die Schnittstelleneinrichtung (110) überbrückenden Bypass-Pfad (BP) der Bypasseinrichtung (120) inaktiviert und
- die Bypasseinrichtung (120) in dem Bypass-Zustand die Pole der ersten äußeren Schnittstelle (A1) der Schnittstellenanordnung (100) mit den korrespondierenden Polen der zweiten äußeren Schnittstelle (A2) der Schnittstellenanordnung (100) verbindet und eine Datensignalübertragung an der Schnittstelleneinrichtung (110) vorbei unter Ausschluss der Schnittstelleneinrichtung (110) erlaubt sowie die Datensignalübertragung zwischen den ersten Schnittstellen (I1, A1) einerseits sowie die Datensignalübertragung zwischen den zweiten Schnittstellen (I2, A2) andererseits für alle Pole unterbindet.

12. Schnittstellenanordnung (100) nach einem der voranstehenden Ansprüche,
**dadurch gekennzeichnet, dass**
die ersten Schnittstellen (I1, A1) und die zweiten Schnittstellen (I2, A2) der Schnittstelleneinrichtung (110) und die der Schnittstellenanordnung (100) jeweils zweipolig sind und die Datensignalübertragung differentiell erfolgt.

13. Schnittstellenanordnung (100) nach einem der voranstehenden Ansprüche,
**dadurch gekennzeichnet, dass**
die interne Schnittstelleneinrichtung (110) eine Single Pair Ethernet (SPE)-kompatible Schnittstelleneinrichtung (110) ist und die Schnittstelleneinrichtung (110) das Empfangen, Auswerten, Erzeugen und Ausgeben von SPE-kompatiblen Datensignalen ermöglicht.

14. Eisenbahnwagen (11),
**dadurch gekennzeichnet, dass**
dieser mit einer Schnittstellenanordnung (100) nach einem der voranstehenden Ansprüche ausgestattet ist.

15. Eisenbahnwagen (11) nach Anspruch 14,
**dadurch gekennzeichnet, dass**
- die erste äußere Schnittstelle (A1) der Schnittstellenanordnung (100) in eine erste digitale automatische Kupplung (12) des Eisenbahnwagens (11) integriert ist und
- die zweite äußere Schnittstelle (A2) der Schnittstellenanordnung (100) in eine zweite digitale automatische Kupplung (13) des Eisenbahnwagens (11) integriert ist.

16. Schienenfahrzeug (10),
**dadurch gekennzeichnet, dass**
- das Schienenfahrzeug (10) einen Verbund, der mit mindestens zwei Eisenbahnwagen (11) nach Anspruch 14 oder 15 ausgestattet ist, die über digitale automatische Kupplungen der Eisenbahnwagen (11) miteinander gekuppelt sind, umfasst oder durch einen solchen gebildet ist,
- wobei in jede der digitalen automatischen Kupplungen des Eisenbahnwagens jeweils eine Schnittstelle (I1) einer Schnittstellenanordnung (100) nach einem der voranstehenden Ansprüche integriert ist.
